Europäisches Patentamt

European Patent Office

Office européen des brevets

(11) Veröffentlichungsnummer: **0 383 280**
**A2**

# (12) EUROPÄISCHE PATENTANMELDUNG

(21) Anmeldenummer: 90102828.2

(22) Anmeldetag: 13.02.90

(51) Int. Cl.5: **H01H 13/70, H03K 17/98**

(30) Priorität: 15.02.89 DE 8901775 U

(43) Veröffentlichungstag der Anmeldung:
22.08.90 Patentblatt 90/34

(84) Benannte Vertragsstaaten:
AT BE CH DE ES FR GB IT LI NL SE

(71) Anmelder: **Siemens Aktiengesellschaft**
**Wittelsbacherplatz 2**
**D-8000 München 2(DE)**

(72) Erfinder: **Unger, Wolfgang, Dipl.-Ing. (FH)**
**Wendelsteinstrasse 9**
**D-8901 Merching(DE)**

(54) Schaltungskarte für eine Tastatur.

(57) Eine Schaltungskarte für eine Tastatur weist als Grundlage eine, mit einer Kupferschicht versehene Trägerkarte auf, bei der eine erste Teilfläche einem Tastenfeld und eine zweite Teilfläche einer Auswerteelektronik zugeordnet ist. Wenigstens im Bereich der zweiten Teilfläche sind in der Kupferschicht durch Freiätzungen Leiterbahnen und/oder Leiterflächen gebildet und wenigstens im Bereich der ersten Teilfläche sind Leiterbahnen und/oder Leiterflächen im Druckverfahren aufgebracht.

EP 0 383 280 A2

## Schaltungskarte für eine Tastatur

Die Erfindung betrifft eine Schaltungskarte gemäß dem Oberbegriff des Patentanspruchs 1.

Solche Schaltungskarten sind bei älteren Tastaturen meistens als Flachbaugruppe ausgebildet, die aus einer mit einer Vielzahl von Tastengehäusen, Entkopplungsdioden und sonstigen Bauelementen bestückten Leiterplatte besteht und damit die gesamte Elektronik der Tastatur darstellt.

Bei Weiterentwicklungen von Tastaturen wurde in verstärktem Maße darauf geachtet, Tastaturen aus möglichst wenig Bauteilen zusammenzustellen und insbesondere die Anzahl der für die Elektronik erforderlichen Bauteile zu verringern.

So ist z.B. in der europäischen Patentanmeldung mit der Anmeldenummer 88 11 39 95.0 eine Tastaturvorrichtung vorgeschlagen worden, bei der die Anzahl der Einzelteile durch ein einteilig ausgestaltetes Tastaturgehäuse und durch Verwendung einer kapazitiven Schaltungskarte erheblich reduziert wurde.

Solche Arten von Schaltungskarten sind in unterschiedlichen Ausführungsformen erhältlich und in der Regel als mehrschichtige flexible Folien mit im wesentlichen planen Oberflächen ausgebildet. Sie dienen lediglich als Träger für eine Vielzahl von in Form eines Tastenfeldes angeordneten Schaltelementen, die jeweils zwei nebeneinanderliegende, zur Verbindung mittels eines Kontaktelementes vorgesehene Leiterflächen aufweisen und im Falle einer kapazitiven Schaltungskarte aus übereinander an geordneten, zu Kondensatorflächen ausgebildeten Leiterflächen bestehen. Die einzelnen Schaltelemente sind auf einer Schaltungskarte untereinander über Zeilen- und Spaltenleitungen verbunden, die in Anschlußflächen an einem Rand der Schaltungskarte enden.

Für eine elektronische Identifizierung einer betätigten Taste und damit eines zugehörigen Schaltelementes sind sämtliche Zeilen- und Spaltenleitungen an eine Auswerteelektronik angeschlossen. In der Regel ist diese Auswerteelektronik auf einer herkömmlichen Flachbaugruppe im Tastaturgehäuse untergebracht und über eine Steckverbindung mit der Schaltungskarte bzw. den darauf befindlichen Zeilen- und Spaltenleitungen verbunden.

Diese Steckverbindung hat sich bei der Montage von Tastaturen als problematisch erwiesen, da das flexible Verhalten solcher Schaltungskarten für einen kraftschlüssigen Steckvorgang ungeeignet ist.

Aufgabe der vorliegenden Erfindung ist es daher, eine Schaltungskarte nach dem Oberbegriff des Schutzanspruchs anzugeben, die einen mehrschichtigen Aufbau, wie bei Schaltungskarten der zuletzt genannten Art erlaubt, und bei der eine Steckverbindung mit der Auswerteelektronik entfallen kann.

Gelöst wird die Aufgabe erfindungsgemäß durch die im kennzeichnenden Teil des Patentanspruchs 1 angegebenen Merkmale.

Mit einer gemeinsamen Leiterkarte für die Schaltelemente und die Bauteile der Auswerteelektronik verringert sich sowohl die Anzahl der für eine funktionsfähige Tastatur benötigten Einzelteile, als auch der bei der Montage einer Tastatur erforderliche Aufwand. Außerdem können etwaige Befestigungsvorrichtungen entfallen, die bisher für die Flachbaugruppe der Auswerteelektronik nötig waren.

Vorteilhafte Weiterbildungen der Erfindung sind in den Unteransprüchen angegeben.

Sieht man als Schaltelemente kapazitive Schaltelemente vor, so können diskrete Entkopplungselemente, wie z.B. Entkopplungsdioden, entfallen.

Eine Schirmungsfläche im Bereich des Tastenfeldes dient bei Verwendung kapazitiver Schaltelemente zur Reduzierung parasitärer Koppelkapazitäten, die den Aufwand für die Auswerteelektronik mitbestimmen.

Mit der erfindungsgemäß ausgebildeten Schaltungskarte ist es auch möglich, optische Anzeigeelemente im Bereich des Tastenfeldes zu plazieren. Solche optische Anzeigeelemente, wie auch andere Bauelemente, können auf Leiterflächen der Kupferschicht, sogenannten Kontaktflecken, befestigt sein, die eine elektrische Verbindung zu im Druckverfahren aufgebrachten Leiterbahnen aufweisen.

Bei Verwendung von Bauteilen für die Oberflächenmontage kann man auf eine Kupferbeschichtung an der Leiterkartenunterseite verzichten. Da die Unterseite der Leiterkarte zudem frei von jeglichen Bauteilen gehalten werden kann, läßt sie sich als Unterseite der Tastaturvorrichtung verwenden, wodurch sich eine zusätzliche Abdeckung einsparen läßt.

Ein Ausführungsbeispiel der Erfindung wird im folgenden anhand der Zeichnung näher erläutert.

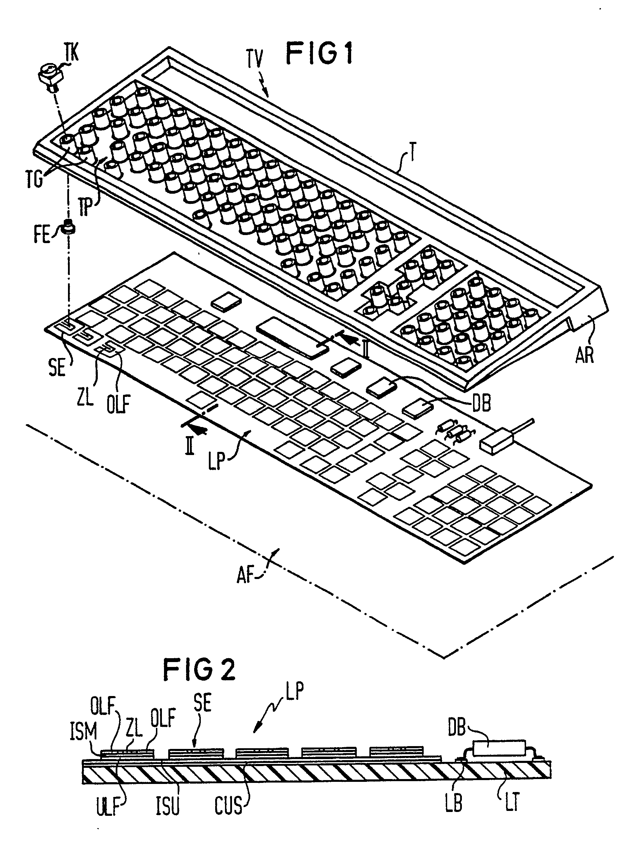

Dabei zeigen FIG 1 eine perspektivische Schrägansicht einer bekannten Tastaturvorrichtung mit einer erfindungsgemäß ausgestalteten Schaltungskarte,

FIG 2 einen Querschnitt durch die in FIG. 1 dargestellte Schaltungskarte entlang der Schnittlinie II-II.

Die FIG 1 zeigt in Explosionsdarstellung eine Tastaturvorrichtung TV, mit einer in einer Zwischenebene oberhalb einer Auflagefläche AF schematisch dargestellten Schaltungskarte LP.

Die Tastaturvorrichtung TV besteht lediglich aus einem als einstückiges Formteil mit einer Tastenplatte TP und einem Auflagerahmen AR ausgebildeten Tastaturgehäuse T.

Die Tastenplatte TP des Tastaturgehäuses T ist als rechteckige, gleichmäßig starke und beidseitig plane Platte ausgestaltet, an deren Oberseite eine Vielzahl von identisch ausgebildeten Tastengehäusen TG angeformt ist. Jedes Tastengehäuse TG ist mit einer schachtartigen, die Tastenplatte TP durchdringenden Öffnung versehen. An der nicht dargestellten Unterseite der Tastenplatte TP sind diese schachtartigen Öffnungen jeweils trichterartig erweitert und bilden dadurch Einbuchtungen, die zur Aufnahme jeweils eines federnden Druckorganes FE vorgesehen sind. Die federnden Druckorgane FE bestehen jeweils aus einem glockenförmigen elastischen Hohlgebilde, in dessen Kuppel sich ein graphitierter Stempel (nicht dargestellt) befindet.

Die federnden Druckorgane FE werden im montierten Zustand der Tastaturvorrichtung TV von der Schaltungskarte LP überdeckt, die an der Unterseite der Tastenplatte TP eben anliegt und an dieser befestigt ist.

Die Oberfläche der Schaltungskarte LP setzt sich aus einer ersten Teilfläche mit kapazitiven Schaltelementen SE und einer zweiten Teilfläche mit diskreten Bauelementen DB zusammen. Die kapazitiven Schaltelemente SE sind jeweils einem Tastengehäuse TG und damit einem in einer Einbuchtung liegenden federnden Druckorgan FE zugeordnet. Jedes kapazitive Schaltelement SE weist zwei übereinanderliegende, zu Kondensatorflächen ausgebildete Leiterflächen auf, eine untere Leiterfläche (in FIG 1 nicht dargestellt), die direkt an eine Spalten- oder Zeilenleitung angeschlossen ist und eine obere Leiterfläche OLF. Dicht neben der oberen Leiterfläche OLF liegt eine Leiterfläche einer Zeilenleitung ZL (bzw. eine Spaltenleitung), die aber keine elektrische Verbindung mit der oberen Leiterfläche OLF aufweist.

Auf der Oberseite der Tastenplatte TP werden die Tastengehäuse TG von Tastenkörpern TK überdeckt, die mit jeweils einem Stößel versehen sind, der in der schachtartigen Öffnung eines jeweiligen Tastengehäuses TG achsial verschiebbar geführt ist.

Beim Niederdrücken eines jeweiligen Tastenkörpers TK führt dessen Stößel den graphitierten Stempel des federnden Druckorganes FE gegen dessen Federkraft an die Schaltungskarte LP und damit an das zugehörige kapazitive Schaltelement SE. Der graphitierte Stempel bildet dann eine galvanische Verbindung zwischen der oberen Leiterfläche OLF und der danebenliegenden Leiterfläche der Zeilenleitung ZL (bzw. Spaltenleitung).

In der FIG 2 ist ein Querschnitt durch die Schaltungskarte LP schematisch dargestellt.

Als Grundelement für die Schaltungskarte LP dient eine einseitig mit einer Kupferschicht CUS bedeckte Trägerkarte LT, wie sie im Handel unter der Bezeichnung "kupferkaschierte Leiterplatte" erhältlich ist.

Diese Kupferschicht CUS ist auf der für die kapazitiven Schaltelemente SE vorgesehenen ersten Teilfläche der Schaltungskarte LP als geschlossene Fläche zu Schirmungszwecken erhalten. Auf der für die diskreten Bauteile DB der Auswerteelektronik bestimmten zweiten Teilfläche ist die Kupferschicht CUS durch Freiätzen stellenweise entfernt worden, so daß die Kupferschicht CUS nur noch in Form von Leiterbahnen LB und Leiterflächen, wie z.B. Kontaktflecken, vorhanden ist. Die Bauteile DB sind in Oberflächenmontage an die Kontaktflecken angeschlossen.

Auf der ersten Teilfläche der Leiterplatte LP ist die Kupferschicht CUS als Ganzes mit einer Isolationsschicht ISU abgedeckt. Auf der Isolationsschicht ISU befinden sich die unteren Leiterflächen ULF der kapazitiven Schaltelemente SE, sowie die an diese unteren Leiterflächen ULF angeschlossenen Leitungen (z.B. Spaltenleitungen - nicht dargestellt).

Abgedeckt sind die unteren Leiterflächen ULF mit ihren Leitungen von einer Isolationszwischenschicht ISM, auf der die zugehörigen oberen Leiterflächen OLF der kapazitiven Schaltelemente SE aufgebracht sind. Dicht bei den einzelnen oberen Leiterflächen OLF verläuft jeweils eine zugehörige Leitung (z.B. Zeilenleitung ZL), deren Oberfläche in einer Ebene mit derjenigen der oberen Leiterfläche OLF liegt.

Beginnend mit der Isolationsschicht ISU sind sämtliche Leiterflächen, Leitungen und Isolationsschichten im Bereich der ersten Teilfläche der Leiterplatte LP im Siebdruckverfahren nacheinander aufgebracht worden.

## Ansprüche

1. Schaltungskarte für eine Tastatur mit einer Vielzahl von auf einer Trägerkarte in Form eines Tastenfeldes angeordneten Schaltelementen, die jeweils wenigstens zwei nebeneinander liegende Leiterflächen aufweisen, und die jeweils über eine Zeilen- und Spaltenleitung an eine Auswerteschaltung angeschlossen sind, **dadurch gekennzeichnet,** daß eine mit einer Kupferschicht (CUS) versehene Trägerkarte (LT), bei der eine erste Teilfläche dem Tastenfeld und eine zweite Teilfläche der Auswerteelektronik zugeordnet ist, wenigstens im Bereich der zweiten Teilfläche in der Kupferschicht (CUS) durch Freiätzungen gebildete Leiterbahnen (LB) und/oder Leiterflächen aufweist und wenigstens im Bereich der ersten Teilfläche mit im Druckverfahren aufgebrachten Leiterbahnen und/oder Leiterflächen versehen ist.

2. Schaltungskarte nach Anspruch 1, **dadurch gekennzeichnet,** daß die Schaltelemente als kapazitive Schaltelemente mit übereinander liegenden, zu Kondensatorflächen ausgestalteten Leiterflächen ausgebildet sind.

3. Schaltungskarte nach Anspruch 2, **dadurch gekennzeichnet,** daß die Kupferschicht im Bereich der ersten Teilfläche als Schirmungsfläche für die kapazitiven Schaltelemente ausgebildet ist.

4. Schaltungskarte nach einem der vorhergehenden Ansprüche, **dadurch gekennzeichnet,** daß die Kupferschicht im Bereich der zweiten Teilfläche für eine Oberflächenmontage von Bauelementen der Auswerteelektronik ausgebildete Leiterflächen aufweist.

5. Schaltungskarte nach einem der vorhergehenden Ansprüche, **dadurch gekennzeichnet,** daß die Kupferschicht im Bereich der ersten Teilfläche für eine Oberflächenmontage von optischen Anzeigeelementen ausgebildete Leiterflächen aufweist.

6. Schaltungskarte nach einem der vorhergehenden Ansprüche, **dadurch gekennzeichnet,** daß die Kupferschicht im Bereich der ersten Teilfläche für eine Oberflächenmontage von zur elektronischen Entkopplung vorgesehenen Bauteilen ausgebildete Leiterflächen aufweist.

7. Schaltungskarte nach einem der vorhergehenen Ansprüche, **dadurch gekennzeichnet,** daß die Trägerkarte an ihrer Unterseite frei von Bauelementen ist.

8. Schaltungskarte nach einem der vorhergehenden Ansprüche, **dadurch gekennzeichnet,** daß die Trägerkarte nur einseitig mit einer Kupferschicht versehen ist.

9. Schaltungskarte nach einem der vorhergehenden Ansprüche, **dadurch gekennzeichnet,** daß die Trägerkarte als flexible Folie ausgebildet ist.

# FIG 1

TK

TV

TG

TP

FE

T

SE

ZL OLF

II

LP

DB

AR

II

AF

# FIG 2

OLF

ISM ZL OLF SE LP

DB

ULF ISU CUS LB LT